# FASCICULE DE BREVET EUROPEEN

(11) **EP 4 148 536 B1**
(45) Date de publication et mention de la délivrance du brevet: **19.11.2025**
(21) Numéro de dépôt: 22194196.6
(22) Date de dépôt: 06.09.2022
(51) Int. Cl.: G06F 1/3234, G11C 5/14

(54) **SYSTÉME ELECTRONIQUE COMPRENANT UNE UNITÉ DE CONTRÔLE CONFIGURÉE POUR COMMUNIQUER AVEC UNE MÉMOIRE**
ELEKTRONISCHES SYSTEM MIT EINER STEUEREINHEIT, DIE ZUR KOMMUNIKATION MIT EINEM SPEICHER KONFIGURIERT IST
ELECTRONIC SYSTEM COMPRISING A CONTROL UNIT CONFIGURED FOR COMMUNICATING WITH A MEMORY

(30) Priorité: 14.09.2021 FR 2109606
(43) Date de publication de la demande: 15.03.2023
(73) Titulaire: STMicroelectronics (Rousset) SAS, 13790 Rousset (FR); STMicroelectronics Design and Application s.r.o., 186 00 Praha 8 (CZ)
(72) Inventeur: LACAN, Jérôme, 13530 TRETS (FR); COLLETTE, Rémi, 13590 MEYREUIL (FR); EVA, Christophe, 13790 ROUSSET (FR); KOMAREK, Milan, 25082 UVALY (CZ)
(74) Mandataire: Casalonga

(56) Documents cités:
- US-A1- 2018 102 776
- US-B1- 9 142 280

## Description

Des modes de réalisation et de mise en œuvre concernent la communication entre une unité de contrôle et un périphérique, par exemple la configuration des entrées/sorties d'une mémoire à partir d'une unité de contrôle telle qu'un microcontrôleur.

Un microcontrôleur comporte des fonctionnalités et une capacité limitée, notamment en termes de mémoire. Afin d'augmenter les fonctionnalités et la capacité du microcontrôleur, il est généralement prévu dans le microcontrôleur au moins une interface d'entrée/sortie configurée pour être connectée électriquement à un périphérique afin de pouvoir communiquer avec ce dernier. Le périphérique peut alors permettre d'augmenter les fonctionnalités ou la capacité du microcontrôleur. Par exemple, le périphérique peut être une mémoire permettant d'augmenter l'espace de stockage du microcontrôleur.

Plus particulièrement, la mémoire comprend au moins une entrée/sortie connectée électriquement à un port d'entrée/sortie du microcontrôleur. Le microcontrôleur comprend des moyens de configuration permettant de configurer chaque entrée/sortie de la mémoire. La configuration de chaque entrée/sortie de la mémoire consiste à définir une valeur de polarisation à appliquer sur l'entrée/sortie de la mémoire. La valeur de polarisation à appliquer sur l'entrée/sortie de la mémoire peut correspondre à un état logique haut ou à un état logique bas.

Par ailleurs, il est possible de définir différents modes d'alimentation du microcontrôleur. L'utilisation de différents modes d'alimentation permet d'éviter une consommation d'énergie inutile pendant des périodes où le microcontrôleur est inactif. En particulier, le microcontrôleur peut être dans un mode d'alimentation dit de fonctionnement (ou mode actif) ou dans un mode de consommation réduite (ou mode repos, en anglais « standby »). Le mode de fonctionnement est utilisé pour alimenter l'ensemble des éléments du microcontrôleur lorsque le microcontrôleur fonctionne normalement. Le mode de consommation réduite est utilisé quand les fonctionnalités du microcontrôleur ne sont pas mises en œuvre, et permet d'alimenter uniquement les éléments du microcontrôleur qui nécessitent d'être maintenus constamment sous tension.

Le microcontrôleur peut ainsi comprendre différents domaines d'alimentation qui sont alimentés en fonction du mode d'alimentation appliqué au microcontrôleur. Chaque domaine d'alimentation comprend un ensemble d'éléments du microcontrôleur qui sont alimentés de la même manière selon le mode d'alimentation activé pour le microcontrôleur.

En particulier, deux domaines d'alimentation peuvent être définis. Un premier domaine peut comprendre un ensemble d'éléments du microcontrôleur devant être alimentés uniquement lorsque le microcontrôleur est dans son mode de fonctionnement. Les éléments du premier domaine ne sont donc pas alimentés lorsque le microcontrôleur est dans son mode de consommation réduite. Un deuxième domaine peut comprendre un ensemble d'éléments du microcontrôleur qu'il convient d'alimenter constamment. Les éléments du deuxième domaine sont donc alimentés lorsque le microcontrôleur est dans son mode de fonctionnement, mais aussi lorsque le microcontrôleur est dans son mode de consommation réduite.

Les moyens de configuration du microcontrôleur permettant la configuration de chaque entrée/sortie sont placées dans le premier domaine d'alimentation. Ainsi, lorsque le microcontrôleur est dans son mode de consommation réduite, ces moyens de configuration ne sont pas alimentés et sont donc réinitialisés. Par conséquent, les moyens de configuration ne sont plus capables de définir la configuration de chaque entrée/sortie de la mémoire lorsque le microcontrôleur est dans son mode de consommation réduite. En particulier, dans ce cas, chaque entrée/sortie de la mémoire devient flottante car le microcontrôleur n'impose pas un état logique haut ou un état logique bas sur cette entrée/sortie. Chaque entrée/sortie est donc dans un état de haute impédance. Or, lorsqu'une entrée/sortie de la mémoire est flottante, la valeur de polarisation qui lui est appliquée est comprise entre la valeur de polarisation correspondant à un état logique haut et celle correspondant à un état logique bas. De la sorte, la valeur de polarisation appliquée sur l'entrée/sortie de la mémoire peut être considérée parfois comme correspondant à un état logique haut et parfois comme correspondant à un état logique bas. Cela peut induire une activation ou une désactivation intempestive de l'entrée/sortie. L'activation intempestive de l'entrée/sortie de la mémoire peut entraîner une configuration indésirable de l'entrée/sortie de la mémoire. Par exemple, l'arrêt de l'alimentation des moyens de configuration peut être à l'origine d'une modification inopinée des données enregistrées dans cette mémoire. L'activation intempestive de l'entrée de la mémoire peut également entraîner des courants de fuite qui réduisent une autonomie d'une batterie alimentant le microcontrôleur.

Il existe donc un besoin de proposer une solution permettant d'assurer une configuration de la mémoire à tout moment, même lorsque l'unité de contrôle est dans son mode de consommation réduite.

Le document US 9 142 280 B1 décrit un système comprenant une unité de contrôle connecté électriquement à une entrée d'une mémoire via une interface de communication, le système comportant deux domaines d'alimentation et des moyens pour configurer une valeur de polarisation de l'entrée de la mémoire.

Selon un aspect, il est proposé un système comprenant une unité de contrôle configurée pour pouvoir être connectée électriquement à une entrée d'une mémoire via une interface de communication, l'unité de contrôle étant adaptée pour présenter deux domaines d'alimentation :
- un premier domaine d'alimentation configuré pour être alimenté lorsque l'unité de contrôle est dans un mode de fonctionnement et pour être éteint lorsque l'unité de contrôle est dans un mode de consommation réduite,
- un deuxième domaine d'alimentation configuré pour être alimenté lorsque l'unité de contrôle est dans le mode de fonctionnement et dans le mode de consommation réduite,
dans lequel l'unité de contrôle comporte dans le premier domaine d'alimentation des premiers moyens de configuration adaptés pour configurer une valeur de polarisation de l'entrée de la mémoire via l'interface de communication lorsque l'unité de contrôle est dans le mode de fonctionnement,
et dans lequel l'unité de contrôle comporte dans le deuxième domaine d'alimentation des deuxièmes moyens de configuration adaptés pour configurer la valeur de polarisation de l'entrée de la mémoire via l'interface de communication lorsque l'unité de contrôle est dans le mode de consommation réduite.

En particulier, le premier domaine d'alimentation comprend un ensemble d'éléments de l'unité de contrôle qui sont alimentés uniquement lorsque l'unité de contrôle est dans ledit mode de fonctionnement et est donc active, afin d'assurer une exécution des fonctionnalités pouvant être mises en œuvre par l'unité de contrôle. Les éléments du premier domaine d'alimentation ne sont donc pas alimentés lorsque ledit mode de consommation réduite est appliqué à l'unité de contrôle afin de réduire la consommation de l'unité de contrôle. Ainsi, les premiers moyens de configuration, qui font partie du premier domaine d'alimentation, ne sont pas alimentés lorsque l'unité de contrôle est dans le mode de consommation réduite. Ces premiers moyens de configuration ne peuvent donc pas être utilisés pour configurer l'entrée de la mémoire lorsque l'unité de contrôle est dans le mode de consommation réduite.

Néanmoins, la configuration de l'entrée de la mémoire lorsque l'unité de contrôle est dans le mode de consommation réduite est permise par les deuxièmes moyens de configuration. En effet, ces deuxièmes moyens de configuration sont compris dans le deuxième domaine d'alimentation et sont donc maintenus sous tension lorsque l'unité de contrôle est dans ledit mode de fonctionnement mais aussi lorsque l'unité de contrôle est dans le mode de consommation réduite. Ainsi, les deuxièmes moyens de configuration peuvent être utilisés pour configurer l'entrée de la mémoire lorsque l'unité de contrôle est dans le mode de consommation réduite.

L'entrée de la mémoire peut ainsi être configurée par les premiers moyens de configuration lorsque l'unité de contrôle est dans ledit mode de fonctionnement et par les deuxièmes moyens de configuration lorsque l'unité de contrôle est dans le mode de consommation réduite.

De la sorte, un état logique est constamment appliqué sur l'entrée de la mémoire. Ainsi, l'entrée de la mémoire n'est jamais flottante. Cela permet de réduire les risques d'activation et de désactivation intempestives de la mémoire. Cela permet également d'éviter une apparition d'un courant de fuite pouvant résulter d'une activation intempestive de la mémoire. Ainsi, la consommation d'énergie du système peut être réduite.

Dans un mode de réalisation avantageux, des circuits de sélection sont configurés pour sélectionner lesdits premiers moyens de configuration pour configurer la valeur de polarisation de l'entrée de la mémoire lorsque l'unité de contrôle est dans le mode de fonctionnement ou lesdits deuxièmes moyens de configuration pour configurer la valeur de polarisation de l'entrée de la mémoire lorsque l'unité de contrôle est dans le mode de consommation réduite.

Les circuits de sélection permettent ainsi de choisir les moyens de configuration permettant de configurer la valeur de polarisation de l'entrée de la mémoire en fonction du mode d'alimentation appliqué à l'unité de contrôle.

Dans un mode de réalisation avantageux, les premiers et deuxièmes moyens de configuration sont adaptés pour appliquer un état logique haut ou un état logique bas à l'entrée de la mémoire.

En appliquant un état logique haut ou bas à l'entrée de la mémoire, les premiers et deuxièmes moyens de configuration maintiennent le contrôle de l'état de l'entrée de la mémoire et empêche celui-ci d'être dans un état de haute impédance.

Dans un mode de réalisation avantageux, une résistance de tirage est configurée pour être reliée à l'interface de communication permettant d'appliquer l'état logique haut à l'entrée de la mémoire, une résistance de rappel est configurée pour être reliée à l'interface de communication permettant d'appliquer l'état logique bas à l'entrée de la mémoire et des commutateurs permettent d'activer ou de désactiver la résistance de tirage et la résistance de rappel selon l'état logique à appliquer à l'entrée de la mémoire défini par les premiers et deuxièmes moyens de configuration. La résistance de tirage et de rappel ainsi que les commutateurs permettent d'appliquer un état logique sur l'entrée de la mémoire de manière simple.

Dans un mode de réalisation avantageux, la résistance de tirage et la résistance de rappel sont prévues dans un port d'entrée/sortie de l'unité de contrôle configuré pour être connecté à l'entrée de la mémoire via l'interface de communication.

Un tel système présente alors l'avantage d'utiliser des résistances de tirage et de rappel qui sont généralement déjà prévues dans les ports d'entrée/sortie d'un microcontrôleur pour appliquer la configuration définie par les premiers et deuxièmes moyens de configuration. Il n'est alors pas nécessaire d'ajouter d'autres résistances de tirage et de rappel dans le système pour appliquer la configuration. Cela permet de faciliter la fabrication du système et de réduire son coût.

Néanmoins, en variante, la résistance de tirage et la résistance de rappel peuvent être reliées à l'interface de communication entre le microcontrôleur et la mémoire.

Dans un mode de réalisation avantageux, les premiers moyens de configuration comprennent un registre de configuration définissant une configuration de la valeur de polarisation de l'entrée de la mémoire lorsque l'unité de contrôle est dans le mode de fonctionnement, ce registre de configuration étant prévu dans un port d'entrée/sortie de l'unité de contrôle configuré pour être connecté à l'entrée de la mémoire via l'interface de communication.

Dans un mode de réalisation avantageux, les deuxièmes moyens de configuration comprennent un registre de configuration définissant une configuration de la valeur de polarisation de l'entrée de la mémoire lorsque l'unité de contrôle est dans le mode de consommation réduite, ce registre de configuration étant prévu dans un port d'entrée/sortie de l'unité de contrôle configuré pour être connecté à l'entrée de la mémoire via l'interface de communication.

Dans un mode de réalisation avantageux, la valeur de polarisation de l'entrée de la mémoire à configurer est adaptée pour activer ou désactiver la mémoire. Les deuxièmes moyens de configuration sont alors adaptés pour configurer cette valeur de polarisation de l'entrée de la mémoire pour désactiver la mémoire lorsque l'unité de contrôle est dans le mode de consommation réduite.

Les deuxièmes moyens de configuration permettent alors de désactiver la mémoire lorsque l'unité de contrôle est dans le mode de consommation réduite. Cela permet de réduire la consommation d'énergie de la mémoire.

En configurant la valeur de polarisation des entrées d'une mémoire, on réduit le risque de modification des informations stockées dans ce type de périphérique notamment lorsque l'unité de contrôle est dans un mode de consommation réduite.

L'invention a également pour objet un procédé de configuration d'une valeur de polarisation d'une entrée d'une mémoire par une unité de contrôle connectée électriquement à l'entrée de la mémoire via une interface de communication, l'unité de contrôle présentant deux domaines d'alimentation : un premier domaine d'alimentation configuré pour être alimenté lorsque l'unité de contrôle est dans un mode de fonctionnement et pour être éteint lorsque l'unité de contrôle est dans un mode de consommation réduite et un deuxième domaine d'alimentation configuré pour être alimenté lorsque l'unité de contrôle est dans le mode de fonctionnement et dans le mode de consommation réduite, le procédé comprenant une configuration de la valeur de polarisation de l'entrée de la mémoire via l'interface de communication à partir de premiers moyens de configuration de l'unité de contrôle placés dans le premier domaine d'alimentation lorsque l'unité de contrôle est dans le mode de fonctionnement ou à partir de deuxièmes moyens de configuration de l'unité de contrôle placés dans le deuxième domaine d'alimentation lorsque l'unité de contrôle est dans le mode de consommation réduite.

Dans un mode de mise en œuvre avantageux, le procédé comprend en outre une sélection par des circuits de sélection desdits premiers moyens de configuration pour configurer la valeur de polarisation de l'entrée de la mémoire lorsque l'unité de contrôle est en mode de fonctionnement et desdits deuxièmes moyens de configuration pour configurer la valeur de polarisation de l'entrée de la mémoire lorsque l'unité de contrôle est en mode de consommation réduite.

Avantageusement, le procédé comprend une application par les premiers et deuxièmes moyens de configuration d'un état logique haut ou d'un état logique bas à l'entrée de la mémoire.

De préférence, l'état logique haut est appliqué par une résistance de tirage configurée pour être reliée à ladite interface de communication et l'état logique bas est appliqué par une résistance de rappel configurée pour être reliée à ladite interface de communication, le procédé comprenant en outre l'activation ou la désactivation par des commutateurs de ladite résistance de tirage et de ladite résistance de rappel selon l'état logique à appliquer à l'entrée de la mémoire défini par lesdits premiers et deuxièmes moyens de configuration.

Dans un mode de mise en œuvre avantageux, la configuration de la valeur de polarisation de l'entrée de la mémoire par les premiers moyens de configuration est définie par un registre de configuration compris dans les premiers moyens de configuration lorsque l'unité de contrôle est dans le mode de fonctionnement, ce registre de configuration étant prévu dans un port d'entrée/sortie de l'unité de contrôle configuré pour être connecté à l'entrée de la mémoire via ladite interface de communication.

Avantageusement, la configuration de la valeur de polarisation de l'entrée de la mémoire par les deuxièmes moyens de configuration est définie par un registre de configuration compris dans les deuxièmes moyens de configuration lorsque l'unité de contrôle est dans le mode de consommation réduite, ce registre de configuration étant prévu dans un port d'entrée/sortie de l'unité de contrôle configuré pour être connecté à l'entrée de la mémoire via ladite interface de communication.

Dans un mode de mise en œuvre avantageux, la valeur de polarisation de l'entrée de la mémoire à configurer est adaptée pour activer ou désactiver la mémoire. Le procédé comprend alors en outre la désactivation de la mémoire lors de la configuration de la valeur de polarisation de l'entrée de la mémoire par les deuxièmes moyens de configuration lorsque l'unité de contrôle est dans le mode de consommation réduite.

D'autres avantages et caractéristiques de l'invention apparaîtront à l'examen de la description détaillée de modes de mise en œuvre et de réalisation, nullement limitatifs, et des dessins annexés sur lesquels :
[Fig 1]
[Fig 2]
[Fig 3]
[Fig 4]
[Fig 5]
[Fig 6]

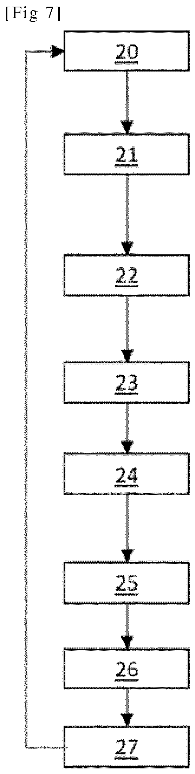

[Fig 7] illustrent schématiquement des modes de réalisation et de mise en œuvre de l'invention.

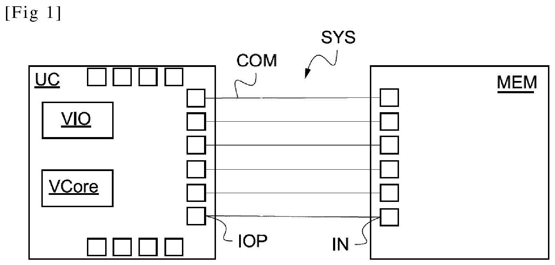

La figure 1 illustre le système SYS selon un mode de réalisation de l'invention. Le système comprend une unité de contrôle UC et une mémoire MEM. L'unité de contrôle UC peut être un microcontrôleur par exemple.

Afin de pouvoir communiquer avec la mémoire MEM, l'unité de contrôle UC comprend des ports d'entrée/sortie IOP connectés électriquement à des entrées/sorties IN de la mémoire MEM via une interface de communication COM. En particulier, l'unité de contrôle UC est adaptée pour configurer les entrées/sorties IN de la mémoire MEM à partir de moyens de configuration décrits ci-dessous.

Par ailleurs, l'unité de contrôle UC est configurée pour être alimentée à partir d'une source d'alimentation, notamment une batterie, selon différents modes d'alimentation. L'utilisation de différents modes d'alimentation permet d'éviter une consommation d'énergie inutile pendant des périodes où l'unité de contrôle UC est inactive. En particulier, l'unité de contrôle UC peut être dans un mode d'alimentation dit de fonctionnement (ou mode actif) ou dans un mode de consommation réduite (ou mode repos, en anglais « standby »). Le mode de fonctionnement est utilisé pour alimenter l'ensemble des éléments de l'unité de contrôle UC lorsque l'unité de contrôle UC fonctionne normalement. Le mode de consommation réduite est utilisé quand les fonctionnalités de l'unité de contrôle UC ne sont pas mises en œuvre. Ce mode de consommation réduite permet d'alimenter uniquement les éléments de l'unité de contrôle UC qui nécessitent d'être maintenus constamment sous tension.

L'unité de contrôle UC comprend ainsi différents domaines d'alimentation qui sont alimentés en fonction du mode d'alimentation appliqué à l'unité de contrôle UC. Chaque domaine d'alimentation comprend un ensemble d'éléments de l'unité de contrôle UC qui sont alimentés de la même manière selon le mode d'alimentation activé pour l'unité de contrôle UC.

En particulier, deux domaines d'alimentation VCore et VIO sont définis. Un premier domaine d'alimentation VCore comprend un ensemble d'éléments de l'unité de contrôle UC devant être alimentés uniquement lorsque l'unité de contrôle UC est dans son mode de fonctionnement. Les éléments du premier domaine d'alimentation VCore ne sont donc pas alimentés lorsque l'unité de contrôle UC est dans son mode de consommation réduite. Un deuxième domaine d'alimentation VIO comprend un ensemble d'éléments de l'unité de contrôle UC qu'il convient d'alimenter constamment. Les éléments du deuxième domaine d'alimentation VIO sont donc alimentés lorsque l'unité de contrôle UC est dans son mode de fonctionnement, mais aussi lorsque l'unité de contrôle UC est dans son mode de consommation réduite. L'unité de contrôle UC peut en outre inclure d'autres premiers domaines d'alimentation VCore et d'autres deuxièmes domaines d'alimentation VIO ainsi qu'éventuellement plusieurs autres domaines d'alimentation. Les autres domaines d'alimentation comprennent alors un ensemble d'éléments de l'unité de contrôle UC devant être alimentés lorsque l'unité de contrôle UC est dans son mode de fonctionnement et pouvant être alimentés ou non lorsque l'unité de contrôle UC est en mode de consommation réduite.

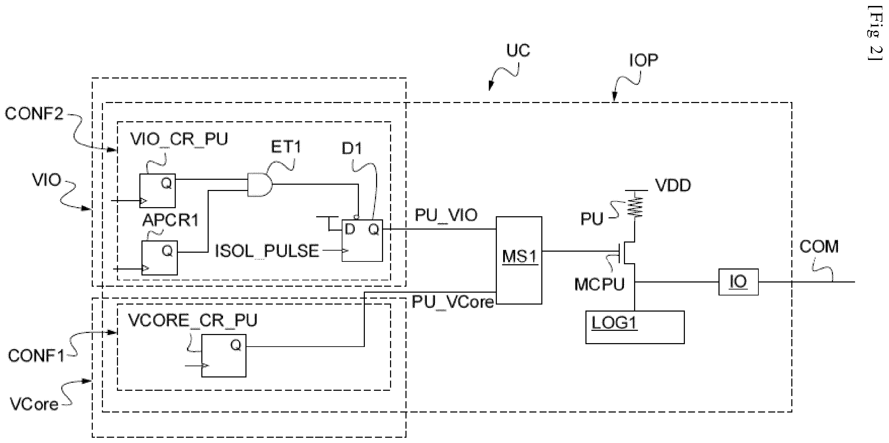

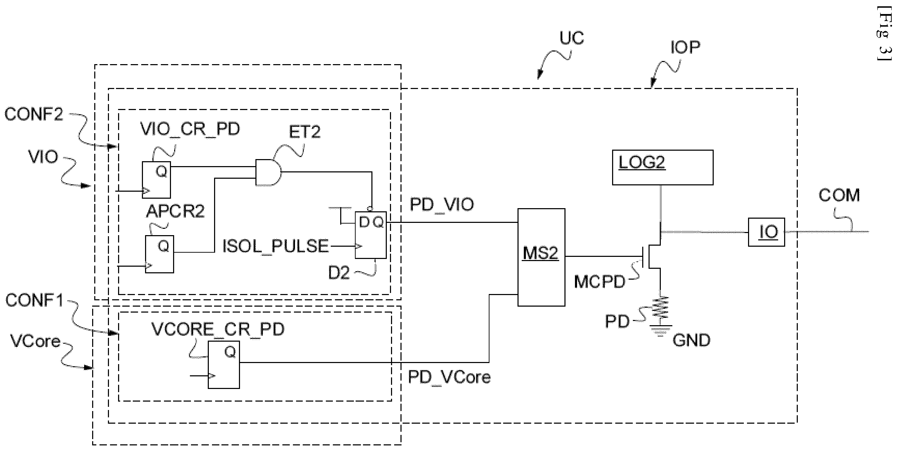

Les figures 2 et 3 illustrent schématiquement un système SYS montrant des modes de réalisation des moyens de configuration de l'unité de contrôle UC. Ces moyens de configuration sont adaptés pour définir une configuration à appliquer sur une entrée IN d'une mémoire MEM.

La configuration de l'entrée IN de la mémoire MEM consiste à appliquer un état logique haut ou un état logique bas sur l'entrée IN de la mémoire MEM.

Afin d'appliquer la configuration définie par les moyens de configuration sur l'entrée IN de la mémoire MEM, le système SYS comprend une résistance de rappel PU et une résistance de tirage PD reliées à l'interface de communication COM connectée à l'entrée IN de la mémoire MEM. Ces résistances de rappel PU et de tirage PD peuvent être activées ou désactivées par des commutateurs MCPU et MCPD selon la configuration définie par les moyens de configuration.

En particulier, la résistance de tirage PU permet d'appliquer l'état logique haut à l'entrée IN de la mémoire MEM, et la résistance de rappel PD permet d'appliquer l'état logique bas à l'entrée IN de la mémoire MEM.

La figure 2 illustre les moyens de configuration permettant d'appliquer un état logique haut sur l'entrée IN de la mémoire MEM à l'aide de la résistance de tirage PU, et la figure 3 illustre les moyens de configuration permettant d'appliquer un état logique bas sur l'entrée IN de la mémoire MEM à l'aide de la résistance de rappel PD.

Plus particulièrement, la résistance de tirage PU présente une première borne reliée à l'interface de communication COM par l'intermédiaire du commutateur MCPU et une deuxième borne reliée à une source d'alimentation VDD. En outre, la résistance de rappel PD présente une première borne reliée à l'interface de communication COM par l'intermédiaire du commutateur MCPD et une deuxième borne reliée à un point froid, notamment une masse GND. Les commutateurs MCPU et MCPD peuvent être des transistor MOS.

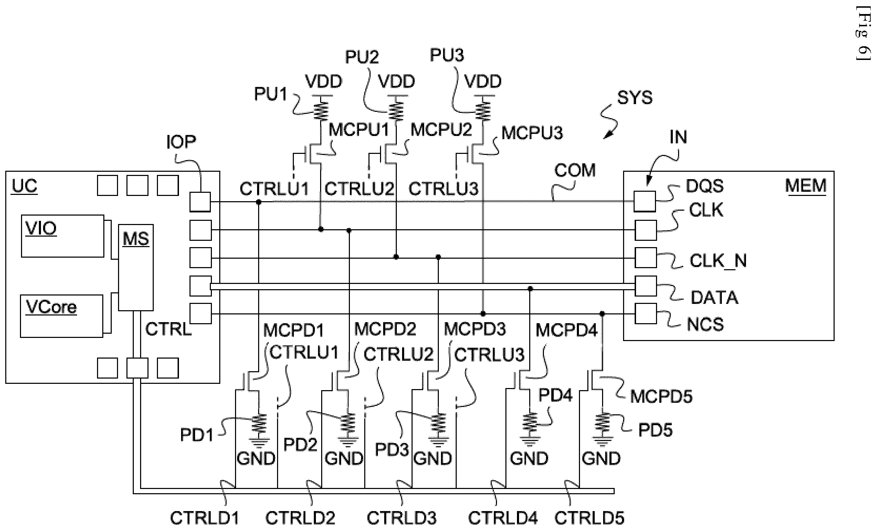

Ici, les résistances de tirage PU et de rappel PD sont intégrées dans des ports d'entrée/sortie IOP de l'unité de contrôle UC. En variante et comme cela sera décrit dans la suite en relation avec la figure 6, il est possible de placer les résistances de tirage PU et de rappel PD à l'extérieur de l'unité de contrôle UC. Néanmoins, l'utilisation de résistances de tirage PU et de rappel PD intégrées dans des ports d'entrée/sortie IOP pour appliquer la configuration définie par les moyens de configuration présente l'avantage de pouvoir utiliser des résistances de tirage PU et de rappel PD déjà prévues généralement dans les ports d'entrée/sortie IOP de l'unité de contrôle UC. Cela permet de faciliter la fabrication du système SYS et de réduire son coût.

Par ailleurs, comme indiqué précédemment, les moyens de configuration permettent de définir la configuration à appliquer sur l'entrée IN de la mémoire MEM. En particulier, les moyens de configuration sont adaptés pour commander les commutateurs MCPU et MCPD associés aux résistances de tirage PU et de rappel PD selon la configuration définie.

Les moyens de configuration, illustrés à la figure 2, permettant d'appliquer un état haut sur l'entrée IN de la mémoire MEM sont identiques aux moyens de configuration, illustrés à la figure 3, permettant d'appliquer un état bas sur l'entrée IN de la mémoire MEM.

Plus particulièrement, l'unité de contrôle UC comporte des premiers moyens de configuration CONF1 compris dans le premier domaine d'alimentation VCore et des deuxièmes moyens de configuration CONF2 compris dans le deuxième domaine d'alimentation VIO.

Ainsi, les premiers moyens de configuration CONF1 sont alimentés uniquement lorsque l'unité de contrôle UC est dans le mode de fonctionnement. Ces premiers moyens de configuration CONF1 sont donc utilisés pour définir la configuration de l'entrée IN de la mémoire MEM uniquement lorsque l'unité de contrôle UC est dans le mode de fonctionnement.

En outre, les deuxièmes moyens de configuration CONF2 sont alimentés lorsque l'unité de contrôle UC est dans le mode de fonctionnement mais aussi lorsque l'unité de contrôle UC est dans le mode de consommation réduite. Ces deuxièmes moyens de configuration CONF2 sont utilisés pour définir la configuration de l'entrée IN de la mémoire MEM lorsque l'unité de contrôle UC est dans le mode de consommation réduite.

L'entrée IN de la mémoire MEM peut ainsi être configurée par les premiers moyens de configuration CONF1 lorsque l'unité de contrôle UC est dans le mode de fonctionnement et par les deuxièmes moyens de configuration CONF2 lorsque l'unité de contrôle UC est dans le mode de consommation réduite.

De la sorte, un état logique est constamment appliqué sur l'entrée IN de la mémoire MEM. Ainsi, l'entrée IN de la mémoire MEM n'est jamais flottante. Cela permet de réduire les risques d'activation et de désactivation intempestives de la mémoire MEM. Cela permet également d'éviter une apparition d'un courant de fuite pouvant résulter d'une activation intempestive de la mémoire MEM. Ainsi, la consommation d'énergie du système SYS peut être réduite.

Plus particulièrement, les premiers moyens de configuration CONF1 comprennent un registre de configuration VCORE_CR_PU définissant une configuration de la valeur de polarisation de l'entrée IN de la mémoire MEM lorsque l'unité de contrôle UC est dans le mode de fonctionnement. Ce registre de configuration VCORE_CR_PU est prévu dans un port d'entrée/sortie IOP de l'unité de contrôle UC configuré pour être connecté à l'entrée IN de la mémoire MEM via l'interface de communication COM.

Le registre de configuration VCORE_CR_PU reçoit en entrée un signal d'activation et peut stocker une configuration de la valeur de polarisation. Lorsque le signal d'activation émet une impulsion, le registre de configuration VCORE_CR_PU stocke une nouvelle configuration de la valeur de polarisation. Cette valeur de polarisation correspond à la valeur de polarisation à configurer à l'entrée IN de la mémoire MEM lorsque l'unité de contrôle UC est dans le mode de fonctionnement.

Les premiers moyens de configuration CONF1 comprennent également un autre registre de configuration VCORE_CR_PD identique au registre de configuration VCORE_CR_PU pouvant stocker une configuration identique ou différente de la valeur de polarisation.

En stockant la configuration de la valeur de polarisation dans le registre de configuration VCORE_CR_PU et VCORE_CR_PD, les premiers moyens de configuration CONF1 peuvent enregistrer la configuration de la valeur de polarisation lorsque l'unité de contrôle UC est dans le mode de fonctionnement. Cette configuration est utilisée afin de configurer la valeur de polarisation de l'entrée IN de la mémoire MEM lorsque l'unité de contrôle UC est dans le mode de fonctionnement.

Les deuxièmes moyens de configuration CONF2 comprennent un registre de configuration VIO_CR_PU définissant une configuration de la valeur de polarisation de l'entrée IN de la mémoire MEM lorsque l'unité de contrôle UC est dans le mode de consommation réduite. Ce registre de configuration VIO_CR_PU est prévu dans un port d'entrée/sortie de l'unité de contrôle UC configuré pour être connecté à l'entrée IN de la mémoire MEM via l'interface de communication COM.

Le registre de configuration VIO_CR_PU reçoit un signal d'activation et peut stocker une configuration de la valeur de polarisation. Lorsque le signal d'activation émet une impulsion, le registre de configuration VIO_CR_PU stocke une nouvelle configuration de la valeur de polarisation. Cette valeur de polarisation correspond à la valeur de polarisation à configurer à l'entrée IN de la mémoire MEM lorsque l'unité de contrôle UC est dans le mode de consommation réduite.

Les deuxièmes moyens de configuration CONF2 comprennent également une porte logique ET1, un registre de contrôle APCR1 et une bascule D1.

Le registre de contrôle APCR1 reçoit en entrée le même signal d'activation et permet d'appliquer ou non la configuration. Les registres VIO_CR_PU et APCR1 transmettent alors respectivement un signal correspondant à la configuration de la valeur de polarisation et un signal de contrôle en entrée de la porte logique ET1. La porte logique ET1 permet, à partir des signaux reçus, de transmettre à la bascule D1 un signal de réinitialisation.

La bascule D1 possède une entrée 'D' toujours fixée à l'état logique haut, une entrée de réinitialisation configurée pour recevoir le signal de réinitialisation, une entrée configurée pour recevoir un signal d'activation ISO_PULSE et une sortie 'Q' permettant de transmettre un signal de commande PU_VIO.

La valeur de l'entrée 'D' correspondant à l'état logique haut est transmise à la sortie 'Q' à chaque impulsion du signal d'activation ISO_PULSE. Cette impulsion correspond à une activation du mode de consommation réduite de l'unité de contrôle UC par l'utilisateur.

Lorsque la bascule D1 reçoit le signal de réinitialisation, la bascule D1 est automatiquement réinitialisée de sorte qu'un état logique bas est transmis à la sortie 'Q'.

Les deuxièmes moyens de configuration CONF2 comprennent également un autre registre de configuration VIO_CR_PD, une autre porte logique ET2, un autre registre de contrôle APCR2 et une autre bascule D2.

Le registre de configuration VIO_CR_PD est identique au registre de configuration VIO_CR_PU et peut stocker une configuration identique ou différente de la valeur de polarisation. La porte logique ET2 et le registre de contrôle APCR2 sont respectivement identiques à la porte logique ET1 et au registre de contrôle APCR1. La bascule D2 est identique à la bascule D1 mais sa sortie 'Q' permet de transmettre un signal de commande PD_VIO.

En stockant la configuration de la valeur de polarisation dans le registre de configuration VIO_CR_PU et VIO_CR_PD, les deuxièmes moyens de configuration CONF2 peuvent enregistrer la configuration de la valeur de polarisation lorsque l'unité de contrôle est dans le mode de fonctionnement. L'utilisateur peut alors choisir d'appliquer ou non cette configuration à un port d'entrée/sortie IOP de l'unité de contrôle UC connecté à l'entrée IN à configurer. Cette configuration est utilisée afin de configurer la valeur de polarisation de l'entrée IN de la mémoire MEM lorsque l'utilisateur active le mode de consommation réduite de l'unité de contrôle UC après le mode de fonctionnement.

Les premiers et deuxièmes moyens de configuration CONF1 et CONF2 sont adaptés pour appliquer un état logique haut à l'entrée IN de la mémoire MEM et un état logique bas à l'entrée IN de la mémoire MEM. L'état logique appliqué définit alors la valeur de polarisation de l'entrée IN de la mémoire MEM et permet d'éviter que cette valeur de polarisation change de manière aléatoire et incontrôlable lorsque l'unité de contrôle UC est en mode de consommation réduite.

Par ailleurs, le système SYS comprend en outre un circuit de sélection MS1, MS2 configuré pour sélectionner les premiers moyens de configuration CONF1 ou les deuxièmes moyens de configuration CONF2 pour configurer l'entrée IN de la mémoire MEM. En particulier, le circuit de sélection MS1, MS2 est configuré pour sélectionner les premiers moyens de configuration CONF1 lorsque l'unité de contrôle UC est dans le mode de fonctionnement, et pour sélectionner les deuxièmes moyens de configuration CONF2 lorsque l'unité de contrôle UC est dans le mode de consommation réduite.

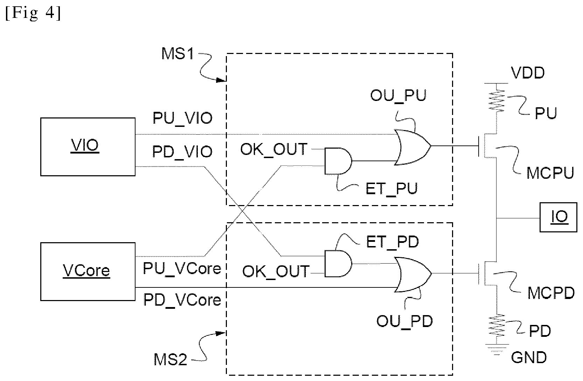

Ce circuit de sélection MS1, MS2 est détaillé à la figure 4.

En particulier, le circuit de sélection comprend un circuit de sélection MS1 pour le contrôle de la résistance de tirage PU et un circuit de sélection MS2 pour le contrôle de la résistance de rappel PD.

Le circuit de sélection MS1 comprend une porte logique ET_PU et une porte logique OU_PU. La porte ET_PU est configurée pour réaliser une opération logique ET entre le signal PU_VCore des premiers moyens de configuration CONF1 et un signal de commande OK_OUT.

Le signal OK_OUT est généré par l'unité de contrôle UC. En particulier, ce circuit peut comprendre un régulateur configuré pour délivrer une tension d'alimentation au domaine d'alimentation VCore. Ainsi, le circuit génère un signal OK_OUT de valeur '1' lorsque le domaine d'alimentation VCore est alimenté et génère un signal OK_OUT de valeur '0' lorsque le domaine d'alimentation VCore n'est pas alimenté.

La porte ET_PU transmet à la porte OU_PU un signal correspondant au résultat de l'opération logique ET. La porte OU_PU est configuré pour réaliser une opération logique OU entre le signal transmis par la porte ET_PU et le signal PU_VIO des deuxièmes moyens de configuration CONF2. La porte OU_PU génère alors un signal correspondant au résultat de l'opération logique OU. Ainsi, selon la valeur du signal OK_OUT reçue par la porte ET_PU, la porte OU_PU peut générer un signal correspondant soit au signal PU_VIO, soit au signal PU_VCore. La porte OU_PU transmet alors ce signal à des commutateurs MCPU.

Le circuit de sélection MS2 comprend une porte logique ET_PD et une porte logique OU_PD. La porte ET_PD est configurée pour réaliser une opération logique ET entre le signal PD_VIO des deuxièmes moyens de configuration CONF2 et un signal de commande OK_OUT. La porte ET_PD transmet à la porte OU_PD un signal correspondant au résultat de l'opération logique ET. La porte OU_PD est configuré pour réaliser une opération logique OU entre le signal transmis par la porte ET_PD et le signal PD_VCore des premiers moyens de configuration CONF1. La porte OU_PD génère alors un signal correspondant au résultat de l'opération logique OU. Ainsi, selon la valeur du signal OK_OUT reçue par la porte ET_PD, la porte OU_PD peut générer un signal correspondant soit au signal PD_VIO, soit au signal PD_VCore. La porte OU_PD transmet alors ce signal à des commutateurs MCPD.

Les commutateurs MCPU permettent d'activer ou de désactiver la résistance de tirage PU.

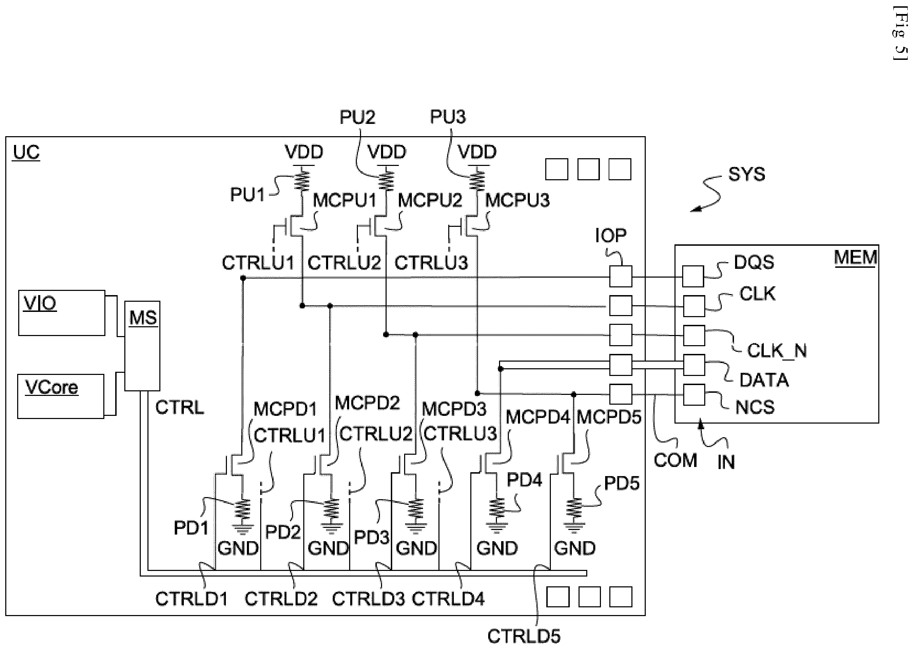

La figure 5 illustre le système de configuration de mémoire selon le premier mode de réalisation dans lequel l'unité de contrôle UC comprend une multitude de ports d'entrée/sortie IOP. Chacun des ports d'entrée/sortie IOP est connecté électriquement à une entrée IN lui étant associée de la mémoire MEM formant ainsi une interface de communication COM. Chaque interface de communication COM permet l'échange de données entre l'unité de contrôle UC et la mémoire MEM. Selon la nature de l'entrée IN de la mémoire MEM, l'utilisateur pourra être amené à respecter un protocole de communication spécifique afin de transmettre des données à cette entrée IN de façon à obtenir la configuration souhaitée de la mémoire MEM.

Par exemple, une mémoire MEM peut présenter des entrées d'horloge CLK et CLK_N, de données DATA, de sélection de périphérique NCS et d'échantillonnage de données DQS.

Dans ce même exemple, les ports d'entrée/sortie IOP de l'unité de contrôle UC sont adaptés pour former une liaison SPI avec les entrées CLK, CLK_N, DATA NCS et DQS afin de configurer la mémoire MEM.

L'unité de contrôle UC comprend un bus de contrôle CTRL et plusieurs circuits de sélection MS. Les circuits de sélection génèrent des signaux de commande CTRLU1, CTRLU2, CTRLU3, CTRLD1, CTRLD2, CTRLD3, CTRLD4 et CTRLD5 pour commander les commutateurs MCPU1, MCPU2, MCPU3, MCPD1, MCPD2 MCPD3, MCPD4 et MCPD5. Le bus de contrôle CTRL permet de connecter chaque circuit de sélection au commutateur associé et permet alors de transmettre les signaux de commande aux commutateurs.

Il convient alors à l'utilisateur d'utiliser le protocole associé au type de liaison formé par les ports d'entrée/sortie IOP de l'unité de contrôle UC et les entrées IN de la mémoire MEM, comme par exemple la liaison SPI.

Dans un protocole de communication comme celui de la SPI, l'entrée NCS permet d'activer ou désactiver la mémoire MEM selon sa valeur de polarisation. Cette entrée NCS est connu sous l'expression anglo-saxonne « Chip Select ». Les deuxièmes moyens de configuration CONF2 sont alors adaptés pour configurer cette valeur de polarisation de l'entrée NCS de la mémoire MEM pour désactiver la mémoire MEM lorsque l'unité de contrôle UC est dans le mode de consommation réduite.

Ainsi, l'utilisateur peut choisir la mémoire MEM avec lequel l'unité de contrôle UC communique en activant ou désactivant la mémoire MEM selon la valeur de polarisation de l'entrée NCS. L'utilisateur peut notamment désactiver la mémoire MEM lorsque l'unité de contrôle UC est en mode de consommation réduite, ce qui permet de réduire la dissipation d'énergie par la mémoire

MEM dans ce mode de consommation réduite.
On peut par exemple prévoir qu'un état logique haut appliqué à l'entrée NCS de la mémoire MEM désactive la mémoire MEM.

Les résistances de tirage PU et de rappel PD sont prévues dans un port d'entrée/sortie IOP de l'unité de contrôle UC configuré pour être connecté à l'entrée IN de la mémoire MEM.

De préférence, chaque port entrée/sortie IOP de l'unité de contrôle UC prévoit à la fois une résistance de tirage PU et une résistance de rappel PD. L'utilisateur pourra ainsi choisir l'état logique à appliquer en entrée IN de la mémoire MEM selon la configuration de la valeur de polarisation qu'il aura préalablement stockée dans le registre VCORE_CR_PU, VCORE_CR_PD, VIO_CR_PU ou encore VIO_CR_PD. Toutefois, une résistance de tirage PU seule peut être prévue dans le port d'entrée/sortie IOP de l'unité de contrôle UC. De même, une résistance de rappel PD seule peut être prévue dans le port d'entrée/sortie IOP de l'unité de contrôle UC.

Comme vu précédemment, le fait d'intégrer les résistances de tirage PU et de rappel PD dans les ports d'entrée/sortie IOP de l'unité de contrôle UC, l'unité de contrôle UC permet de simplifier la fabrication du système.

Néanmoins, en variante, les résistances de tirage PU et de rappel PD peuvent être reliées à l'interface de communication COM entre l'unité de contrôle UC et la mémoire MEM, comme représenté sur la figure 6.

En particulier, la figure 6 illustre le système de configuration de mémoire selon un deuxième mode de réalisation dans lequel le système SYS est identique au système SYS de la figure 5 à l'exception que les résistances de tirage PU et de rappel PD ainsi que les commutateurs MCPU et MCPD sont reliées à l'interface de communication COM tout en étant placés à l'extérieur de l'unité de contrôle UC.

L'utilisateur peut alors concevoir un circuit incluant ses propres résistances de tirage PU et de rappel PD ainsi que ses propres commutateurs MCPU et MCPD. Ce circuit peut ainsi être connecté à l'interface de communication COM et être piloté par une unité de contrôle UC ne disposant pas de moyens permettant d'appliquer un état logique en entrée IN de la mémoire MEM.

Sur cette même figure 6, des résistances de tirage PU1, PU2 et PU3 sont reliés à une source d'alimentation VDD et sont respectivement reliés aux sources de MCPU1, MCPU2 et MCPU3. Les drains de MCPU1, MCPU2 et MCPU3 sont respectivement reliées aux entrées CLK, CLK_N et NCS de la mémoire MEM. Des résistances de rappel PD1, PD2, PD3, PD4 et PD5 sont respectivement reliées aux sources de MCPD1, MCPD2, MCPD3, MCPD4. Les drains de MCPD1, MCPD2, MCPD3, MCPD4 et MCPD5 sont respectivement reliées aux entrées DQS, CLK, CLK_N, DATA et NCS de la mémoire MEM.

L'unité de contrôle UC comprend un bus de contrôle CTRL relié à un de ses ports d'entrée/sortie IOP et plusieurs circuits de sélection MS. Les circuits de sélection génèrent des signaux de commande CTRLU1, CTRLU2, CTRLU3, CTRLD1, CTRLD2, CTRLD3, CTRLD4 et CTRLD5 pour commander les commutateurs MCPU1, MCPU2, MCPU3, MCPD1, MCPD2 MCPD3, MCPD4 et MCPD5. Le bus de contrôle CTRL permet de connecter chaque circuit de sélection au commutateur associé et permet alors de transmettre les signaux de commande aux commutateurs.

La figure 7 illustre un mode de mise en œuvre d'un procédé de configuration d'une mémoire MEM, plus particulièrement la configuration de la valeur de polarisation de l'entrée IN de la mémoire MEM par une unité de contrôle UC connectée électriquement à l'entrée IN de la mémoire MEM via une interface de communication COM. Ce procédé de configuration peut être mis en œuvre par le système SYS décrit précédemment.

Ce procédé comprend une configuration de la valeur de polarisation de l'entrée IN de la mémoire MEM via l'interface de communication COM à partir des premiers moyens de configuration CONF1 de l'unité de contrôle UC lorsque l'unité de contrôle UC est dans le mode de fonctionnement ou à partir des deuxièmes moyens de configuration CONF2 de l'unité de contrôle UC lorsque l'unité de contrôle UC est dans le mode de consommation réduite.

En particulier, l'unité de contrôle UC est configurée pour recevoir des instructions d'un utilisateur et pour changer de mode selon ces instructions.

La figure 7 illustre plus précisément un exemple de procédé de configuration de mémoire MEM dans lequel l'unité de contrôle est tout d'abord en mode de fonctionnement avant de passer ensuite en mode de consommation réduite pour enfin revenir en mode de fonctionnement.

A l'étape 20, l'unité de contrôle UC est donc en mode de fonctionnement et les domaines VCore et VIO sont alimentés. Le contenu des registres APCR1 et APCR2 est à '0' afin d'empêcher la configuration des entrées IN de la mémoire MEM par les deuxièmes moyens de configuration CONF2. Les premiers moyens de configuration CONF1 utilisent la valeur contenue dans les registres de configuration VCORE_CR_PU et VCORE_CR_PD pour générer les signaux de commande PU_VCore et PD_VCore. Comme indiqué précédemment, ces signaux PU_VCore et PD_VCore permettent de configurer la valeur de polarisation de l'entrée IN de la mémoire MEM.

Par ailleurs, l'unité de contrôle UC génère un signal de commande OK_OUT de valeur '1' en entrée des circuits de sélection MS1 et MS2 lorsque l'unité de contrôle UC est dans ledit mode de fonctionnement.

Le procédé de configuration comprend en outre une étape 21 de sélection par les circuits de sélection MS1 et MS2 des premiers moyens de configuration CONF1. Cette étape 21correspond plus précisément à la sélection mentionnée précédemment des signaux de commande PU_VCore et PD_VCore générés par les premiers moyens de configuration CONF1 pour configurer la valeur de polarisation de l'entrée IN de la mémoire MEM.

A l'étape 22, le signal de commande sélectionné PU_VCore est transmis par le circuit de sélection MS1 au commutateur MCPU. Selon la valeur de ce signal de commande correspondant à la configuration à appliquer en entrée IN de la mémoire MEM, le commutateur MCPU peut être passant ou bloqué. De même, le signal de commande sélectionné PD_VCore est transmis par le circuit de sélection MS2 au commutateur MCPD. Selon la valeur de ce signal de commande correspondant à la configuration à appliquer en entrée IN de la mémoire MEM, le commutateur MCPD peut être passant ou bloqué.

Par exemple, le commutateur MCPD est passant pour une valeur de configuration transmis par le signal PD_VCore. Le commutateur MCPD active alors la résistance de rappel PD pour appliquer un état logique bas à l'entrée IN de la mémoire MEM.

De même, le commutateur MCPU est passant pour une valeur de configuration transmis par le signal PU_VCore. Le commutateur MCPU active alors la résistance de tirage PU pour appliquer un état logique haut à l'entrée IN de la mémoire MEM.

A l'étape 23, le contenu des registres de configuration VIO_CR_PU et VIO_CR_PD ainsi que le contenu des registres APCR1 et APCR2 sont modifiés de façon à permettre la configuration de l'entrée IN de la mémoire MEM par les deuxièmes moyens de configuration CONF2 lorsque l'unité de contrôle est en mode de consommation réduite. Le fonctionnement des registres VIO_CR_PU, VIO_CR_PD, APCR1 et APCR2 des deuxièmes moyens de configuration CONF2 reste le même que celui expliqué précédemment.

A l'étape 24, l'unité de contrôle passe en mode de consommation réduite. Le domaine d'alimentation VCore est alors éteint et le domaine d'alimentation VIO continue d'être alimenté. L'unité de contrôle UC génère un signal de commande OK_OUT de valeur '0' en entrée des circuits de sélection MS1 et MS2 et l'unité de contrôle UC génère un signal ISO_PULSE en entrée des bascules D1 et D2. Les deuxièmes moyens de configuration CONF2 utilisent alors la valeur contenue dans les registres de configuration VIO_CR_PU et VIO_CR_PD pour générer les signaux de commande PU_VIO et PD_VIO. Comme indiqué précédemment, ces signaux PU_VIO et PD_VIO permettent de configurer la valeur de polarisation de l'entrée IN de la mémoire MEM.

Le procédé de configuration comprend en outre une étape 25 de sélection par les circuits de sélection MS1 et MS2 des deuxièmes moyens de configuration CONF2. Cette étape 25 correspond plus précisément à la sélection mentionnée précédemment des signaux de commande PU_VIO et PD_VIO générés par les deuxièmes moyens de configuration CONF2 pour configurer la valeur de polarisation de l'entrée IN de la mémoire MEM.

A l'étape 26, le signal de commande sélectionné PU_VIO est transmis par le circuit de sélection MS1 au commutateur MCPU. Selon la valeur de ce signal de commande correspondant à la configuration à appliquer en entrée IN de la mémoire MEM, le commutateur MCPU peut être passant ou bloqué. De même, le signal de commande sélectionné PD_VIO est transmis par le circuit de sélection MS2 au commutateur MCPD. Selon la valeur de ce signal de commande correspondant à la configuration à appliquer en entrée IN de la mémoire MEM, le commutateur MCPD peut être passant ou bloqué.

Par exemple, le commutateur MCPD est passant pour une valeur de configuration transmis par le signal PD_VIO. Le commutateur MCPD active alors la résistance de rappel PD pour appliquer un état logique bas à l'entrée IN de la mémoire MEM.

De même, le commutateur MCPU est passant pour une valeur de configuration transmis par le signal PU_VIO. Le commutateur MCPU active alors la résistance de tirage PU pour appliquer un état logique haut à l'entrée IN de la mémoire MEM.

Plus particulièrement, un état logique haut peut être appliqué par la résistance de tirage PU3 à l'entrée NCS de la mémoire MEM lorsque MCPU3 est passant à l'étape 26. MCPU3 est passant lorsque le signal CTRLU3 est à l'état logique bas par exemple. La mémoire MEM est alors désactivé, notamment lorsque l'unité de contrôle UC est en mode de consommation réduite et donc lorsque le signal CTRLU3 correspond au signal de commande PU_VIO généré par les deuxièmes moyens de configuration CONF2.

Enfin, dans une étape 27, l'unité de contrôle UC passe en mode de fonctionnement, le domaine d'alimentation VCore est de nouveau alimenté et le contenu des registres VCORE_CR_PU et VCORE_CR_PD est réinitialisé. Il convient alors de modifier le contenu de ces registres VCORE_CR_PU et VCORE_CR_PD afin de permettre la configuration des entrées IN de la mémoire MEM par les premiers moyens de configuration CONF1, et de désactiver les deuxièmes moyens de configuration en mettant à '0' le contenu des registres APCR1 et APCR2. Le procédé peut alors continuer à partir de l'étape 20.

## Revendications

1. Système (SYS) comprenant une unité de contrôle (UC) configurée pour pouvoir être connectée électriquement à une entrée (IN) d'une mémoire (MEM) via une interface de communication (COM), l'unité de contrôle (UC) étant adaptée pour présenter deux domaines d'alimentation :
- un premier domaine d'alimentation (VCore) configuré pour être alimenté lorsque l'unité de contrôle (UC) est dans un mode de fonctionnement et pour être éteint lorsque l'unité de contrôle (UC) est dans un mode de consommation réduite,
- un deuxième domaine d'alimentation (VIO) configuré pour être alimenté lorsque l'unité de contrôle (UC) est dans le mode de fonctionnement et dans le mode de consommation réduite,
dans lequel l'unité de contrôle (UC) comporte dans le premier domaine d'alimentation (VCore) des premiers moyens de configuration (CONF1) adaptés pour configurer une valeur de polarisation de ladite entrée (IN) de la mémoire (MEM) via l'interface de communication (COM) lorsque l'unité de contrôle (UC) est dans le mode de fonctionnement,
et **caractérisé en ce que**
l'unité de contrôle (UC) comporte dans le deuxième domaine d'alimentation (VIO) des deuxièmes moyens de configuration (CONF2) adaptés pour configurer la valeur de polarisation de ladite entrée (IN) de la mémoire (MEM) via l'interface de communication (COM) lorsque l'unité de contrôle (UC) est dans le mode de consommation réduite.

2. Système (SYS) selon la revendication 1, comprenant en outre des circuit de sélection (MS1 et MS2) configurés pour sélectionner lesdits premiers moyens de configuration (CONF1) pour configurer la valeur de polarisation de ladite entrée (IN) de la mémoire (MEM) lorsque l'unité de contrôle (UC) est dans le mode de fonctionnement ou lesdits deuxièmes moyens de configuration (CONF2) pour configurer la valeur de polarisation de ladite entrée (IN) de la mémoire (MEM) lorsque l'unité de contrôle (UC) est dans le mode de consommation réduite.

3. Système (SYS) selon l'une quelconque des revendications 1 ou 2, dans lequel les premiers et deuxièmes moyens de configuration (CONF1 et CONF2) sont adaptés pour appliquer un état logique haut ou un état logique bas à l'entrée (IN) de la mémoire (MEM).

4. Système (SYS) selon la revendication 3, comprenant en outre :
- une résistance de tirage (PU) configurée pour être reliée à ladite interface de communication (COM) permettant d'appliquer l'état logique haut à l'entrée (IN) de la mémoire (MEM),
- une résistance de rappel (PD) configurée pour être reliée à ladite interface de communication (COM) permettant d'appliquer l'état logique bas à l'entrée (IN) de la mémoire (MEM),
- des commutateurs (MCPU, MCPD) permettant d'activer ou de désactiver ladite résistance de tirage (PU) et ladite résistance de rappel (PD) selon l'état logique à appliquer à l'entrée (IN) de la mémoire (MEM) défini par lesdits premiers et deuxièmes moyens de configuration (CONF1 et CONF2).

5. Système (SYS) selon la revendication 4, dans lequel ladite résistance de tirage (PU) et ladite résistance de rappel (PD) sont prévues dans un port d'entrée/sortie (IOP) de l'unité de contrôle (UC) configuré pour être connecté à l'entrée (IN) de la mémoire (MEM) via ladite interface de communication (COM).

6. Système (SYS) selon la revendication 4 comprenant :
- la mémoire (MEM),
- ladite interface de communication (COM) reliant la mémoire (MEM) à l'unité de contrôle (UC), et dans lequel ladite résistance de tirage (PU) et ladite résistance de rappel (PD) sont reliée à l'interface de communication (COM) entre l'unité de contrôle (UC) et la mémoire (MEM).

7. Système (SYS) selon l'une des revendications 1 à 6, dans lequel les premiers moyens de configuration (CONF1) comprennent un registre de configuration (VCORE_CR_PU, VCORE_CR_PD) définissant une configuration de la valeur de polarisation de l'entrée (IN) de la mémoire (MEM) lorsque l'unité de contrôle (UC) est dans le mode de fonctionnement, ce registre de configuration (VCORE_CR_PU, VCORE_CR_PD) étant prévu dans un port d'entrée/sortie (IOP) de l'unité de contrôle (UC) configuré pour être connecté à l'entrée (IN) de la mémoire (MEM) via ladite interface de communication (COM).

8. Système (SYS) selon l'une des revendications 1 à 7, dans lequel les deuxièmes moyens de configuration (CONF2) comprennent un registre de configuration (VIO_CR_PU, VIO_CR_PD) définissant une configuration de la valeur de polarisation de l'entrée (IN) de la mémoire (MEM) lorsque l'unité de contrôle (UC) est dans le mode de consommation réduite, ce registre de configuration (VIO_CR_PU, VIO_CR_PD) étant prévu dans un port d'entrée/sortie (IOP) de l'unité de contrôle (UC) configuré pour être connecté à l'entrée (IN) de la mémoire (MEM) via ladite interface de communication (COM).

9. Système (SYS) selon l'une des revendications 1 à 8, dans lequel la valeur de polarisation de l'entrée (IN) de la mémoire (MEM) à configurer est adaptée pour activer ou désactiver la mémoire(MEM), et dans lequel les deuxièmes moyens de configuration (CONF2) sont adaptés pour configurer cette valeur de polarisation de l'entrée (IN) de la mémoire (MEM) pour désactiver la mémoire (MEM) lorsque l'unité de contrôle (UC) est dans le mode de consommation réduite.

10. Procédé de configuration d'une valeur de polarisation d'une entrée (IN) d'une mémoire (MEM) par une unité de contrôle (UC) connectée électriquement à l'entrée (IN) de la mémoire (MEM) via une interface de communication (COM), l'unité de contrôle (UC) présentant deux domaines d'alimentation :
- un premier domaine d'alimentation (VCore) configuré pour être alimenté lorsque l'unité de contrôle (UC) est dans un mode de fonctionnement et pour être éteint lorsque l'unité de contrôle (UC) est dans un mode de consommation réduite,
- un deuxième domaine d'alimentation (VIO) configuré pour être alimenté lorsque l'unité de contrôle (UC) est dans le mode de fonctionnement et dans le mode de consommation réduite, le procédé comprenant une configuration de la valeur de polarisation de l'entrée (IN) de la mémoire (MEM) via l'interface de communication (COM) à partir de premiers moyens de configuration (CONF1) de l'unité de contrôle (UC) placés dans le premier domaine d'alimentation (VCore) lorsque l'unité de contrôle (UC) est dans le mode de fonctionnement ou à partir de deuxièmes moyens de configuration (CONF2) de l'unité de contrôle (UC) placés dans le deuxième domaine d'alimentation (VIO) lorsque l'unité de contrôle (UC) est dans le mode de consommation réduite.

11. Procédé selon la revendication 10, comprenant en outre une sélection par des circuit de sélection (MS1, MS2) desdits premiers moyens de configuration (CONF1) pour configurer la valeur de polarisation de l'entrée (IN) de la mémoire (MEM) lorsque l'unité de contrôle (UC) est en mode de fonctionnement et desdits deuxièmes moyens de configuration (CONF2) pour configurer la valeur de polarisation de l'entrée (IN) de la mémoire (MEM) lorsque l'unité de contrôle (UC) est en mode de consommation réduite.

12. Procédé selon la revendication 10 ou 11, comprenant une application par les premiers et deuxièmes moyens de configuration (CONF1 et CONF2) d'un état logique haut ou d'un état logique bas à l'entrée (IN) de la mémoire (MEM).

13. Procédé selon la revendication 12, dans lequel :
- l'état logique haut est appliqué par une résistance de tirage (PU) configurée pour être reliée à ladite interface de communication (COM),
- l'état logique bas est appliqué par une résistance de rappel (PD) configurée pour être reliée à ladite interface de communication (COM), le procédé comprenant en outre l'activation ou la désactivation par des commutateurs (MCPU, MCPD) de ladite résistance de tirage (PU) et de ladite résistance de rappel (PD) selon l'état logique à appliquer à l'entrée (IN) de la mémoire (MEM) défini par lesdits premiers et deuxièmes moyens de configuration (CONF1 et CONF2).

14. Procédé selon la revendication 13, dans lequel ladite résistance de tirage (PU) et ladite résistance de rappel (PD) sont prévues dans un port d'entrée/sortie (IOP) de l'unité de contrôle (UC) configuré pour être connecté à l'entrée (IN) de la mémoire (MEM) via ladite interface de communication (COM).

15. Procédé selon la revendication 13, dans lequel ladite résistance de tirage (PU) et ladite résistance de rappel (PD) sont reliée à l'interface de communication (COM) entre l'unité de contrôle (UC) et la mémoire (MEM).

16. Procédé selon l'une des revendications 10 à 15, dans lequel la configuration de la valeur de polarisation de l'entrée (IN) de la mémoire (MEM) par les premiers moyens de configuration (CONF1) est définie par un registre de configuration (IPORT_PU, VCORE_CR_PD) compris dans les premiers moyens de configuration (CONF1) lorsque l'unité de contrôle (UC) est dans le mode de fonctionnement, ce registre de configuration (IPORT_PU, VCORE_CR_PD) étant prévu dans un port d'entrée/sortie (IOP) de l'unité de contrôle (UC) configuré pour être connecté à l'entrée (IN) de la mémoire (MEM) via ladite interface de communication (COM).

17. Procédé selon l'une des revendications 10 à 16, dans lequel la configuration de la valeur de polarisation de l'entrée (IN) de la mémoire (MEM) par les deuxièmes moyens de configuration (CONF2) est définie par un registre de configuration (VIO_CR_PU, VIO_CR_PD) compris dans les deuxièmes moyens de configuration (CONF2) lorsque l'unité de contrôle (UC) est dans le mode de consommation réduite, ce registre de configuration (VIO_CR_PU, VIO_CR_PD) étant prévu dans un port d'entrée/sortie (IOP) de l'unité de contrôle (UC) configuré pour être connecté à l'entrée (IN) de la mémoire (MEM) via ladite interface de communication (COM).

18. Procédé selon l'une des revendications 10 à 17, dans lequel la valeur de polarisation de l'entrée (IN) de la mémoire (MEM) à configurer est adaptée pour activer ou désactiver la mémoire (MEM), le procédé comprenant en outre une désactivation de la mémoire (MEM) lors de la configuration de la valeur de polarisation de l'entrée (IN) de la mémoire (MEM) par les deuxièmes moyens de configuration (CONF2) lorsque l'unité de contrôle (UC) est dans le mode de consommation réduite.

## Patentansprüche

1. System (SYS), das eine Steuereinheit (UC) umfasst, die so konfiguriert ist, dass sie über eine Kommunikationsschnittstelle (COM) elektrisch an einen Eingang (IN) eines Speichers (MEM) angeschlossen werden kann, wobei die Steuereinheit (UC) geeignet ist, zwei Versorgungsbereiche aufzuweisen:
- einen ersten Versorgungsbereich (VCore), der so konfiguriert ist, dass er versorgt wird, wenn sich die Steuereinheit (UC) in einem Betriebsmodus befindet, und dass er ausgeschaltet wird, wenn sich die Steuereinheit (UC) in einem Modus mit reduziertem Verbrauch befindet,
- einen zweiten Versorgungsbereich (VIO), der so konfiguriert ist, dass er versorgt wird, wenn sich die Steuereinheit (UC) in dem Betriebsmodus und in dem Modus mit reduziertem Verbrauch befindet,
wobei die Steuereinheit (UC) in dem ersten Versorgungsbereich (VCore) erste Konfigurationsmittel (CONF1) umfasst, die geeignet sind, einen Polarisationswert des Eingangs (IN) des Speichers (MEM) über die Kommunikationsschnittstelle (COM) zu konfigurieren, wenn sich die Steuereinheit (UC) in dem Betriebsmodus befindet, und **dadurch gekennzeichnet ist, dass** die Steuereinheit (UC) in dem zweiten Versorgungsbereich (VIO) zweite Konfigurationsmittel (CONF2) umfasst, die geeignet sind, den Polarisationswert des Eingangs (IN) des Speichers (MEM) über die Kommunikationsschnittstelle (COM) zu konfigurieren, wenn sich die Steuereinheit (UC) in dem Modus mit reduziertem Verbrauch befindet.

2. System (SYS) nach Anspruch 1, ferner umfassend Auswahlschaltungen (MS1 und MS2), die so konfiguriert sind, dass sie die ersten Konfigurationsmittel (CONF1) auswählen, um den Polarisationswert des Eingangs (IN) des Speichers (MEM) zu konfigurieren, wenn sich die Steuereinheit (UC) in dem Betriebsmodus befindet, oder die zweiten Konfigurationsmittel (CONF2), um den Polarisationswert des Eingangs (IN) des Speichers (MEM) zu konfigurieren, wenn die Steuereinheit (UC) sich in dem Modus mit reduziertem Verbrauch befindet.

3. System (SYS) nach einem der Ansprüche 1 oder 2, wobei die ersten und zweiten Konfigurationsmittel (CONF1 und CONF2) geeignet sind, einen logischen High-Zustand oder einen logischen Low-Zustand an den Eingang (IN) des Speichers (MEM) anzulegen.

4. System (SYS) nach Anspruch 3, ferner umfassend:
- einen Pull-up-Widerstand (PU), der so konfiguriert ist, dass er mit der Kommunikationsschnittstelle (COM) verbunden werden kann, die das Anlegen des logischen High-Zustands an den Eingang (IN) des Speichers (MEM) ermöglicht,
- einen Rückstellwiderstand (PD), der so konfiguriert ist, dass er mit der Kommunikationsschnittstelle (COM) verbunden werden kann, die das Anlegen des logischen Low-Zustands an den Eingang (IN) des Speichers (MEM) ermöglicht,
- Schalter (MCPU, MCPD), die das Aktivieren oder Deaktivieren des Pull-up-Widerstands (PU) und des Rückstellwiderstands (PD) je nach dem logischen Zustand ermöglicht, der an den Eingang (IN) des Speichers (MEM) angelegt werden soll, der durch die ersten und zweiten Konfigurationsmittel (CONF1 und CONF2) definiert ist.

5. System (SYS) nach Anspruch 4, wobei der Pull-up-Widerstand (PU) und der Rückstellwiderstand (PD) IN einem Eingangs-/Ausgangsanschluss (IOP) der Steuereinheit (UC) vorgesehen sind, der so konfiguriert ist, dass er über die Kommunikationsschnittstelle (COM) mit dem Eingang (IN) des Speichers (MEM) verbunden ist.

6. System (SYS) nach Anspruch 4, umfassend:
- den Speicher (MEM),
- die Kommunikationsschnittstelle (COM), die den Speicher (MEM) mit der Steuereinheit (UC) verbindet, und wobei der Pull-up-Widerstand (PU) und der Rückstellwiderstand (PD) mit der Kommunikationsschnittstelle (COM) zwischen der Steuereinheit (UC) und dem Speicher (MEM) verbunden sind.

7. System (SYS) nach einem der Ansprüche 1 bis 6, wobei die ersten Konfigurationsmittel (CONF1) ein Konfigurationsregister (VCORE_CR_PU, VCORE_CR_PD) umfassen, das eine Konfiguration des Polarisationswerts des Eingangs (IN) des Speichers (MEM) definiert, wenn sich die Steuereinheit (UC) in dem Betriebsmodus befindet, wobei dieses Konfigurationsregister (VCORE_CR_PU, VCORE_CR_PD) in einem Eingangs-/Ausgangsanschluss (IOP) der Steuereinheit (UC) vorgesehen ist, der so konfiguriert ist, dass er über die Kommunikationsschnittstelle (COM) mit dem Eingang (IN) des Speichers (MEM) verbunden werden kann.

8. System (SYS) nach einem der Ansprüche 1 bis 7, wobei die zweiten Konfigurationsmittel (CONF2) ein Konfigurationsregister (VIO_CR_PU, VIO_CR_PD) umfassen, das eine Konfiguration des Polarisationswerts des Eingangs (IN) des Speichers (MEM) definiert, wenn sich die Steuereinheit (UC) in dem Modus mit reduziertem Verbrauch befindet, wobei dieses Konfigurationsregister (VIO_CR_PU, VIO_CR_PD) in einem Eingangs-/Ausgangsanschluss (IOP) der Steuereinheit (UC) vorgesehen ist, der so konfiguriert ist, dass er über die Kommunikationsschnittstelle (COM) mit dem Eingang (IN) des Speichers (MEM) verbunden werden kann.

9. System (SYS) nach einem der Ansprüche 1 bis 8, wobei der Polarisationswert des Eingangs (IN) des zu konfigurierenden Speichers (MEM) geeignet ist, den Speicher (MEM) zu aktivieren oder deaktivieren, und wobei die zweiten Konfigurationsmittel (CONF2) geeignet sind, diesen Polarisationswert des Eingangs (IN) des Speichers (MEM) zum Deaktivieren des Speichers (MEM) zu konfigurieren, wenn sich die Steuereinheit (UC) in dem Modus mit reduziertem Verbrauch befindet.

10. Verfahren zum Konfigurieren eines Polarisationswerts eines Eingangs (IN) eines Speichers (MEM) durch eine Steuereinheit (UC), die elektrisch über eine Kommunikationsschnittstelle (COM) mit dem Eingang (IN) des Speichers (MEM) verbunden ist, wobei die Steuereinheit (UC) zwei Versorgungsbereiche aufweist:
- einen ersten Versorgungsbereich (VCore), der so konfiguriert ist, dass er versorgt wird, wenn sich die Steuereinheit (UC) in einem Betriebsmodus befindet, und dass er ausgeschaltet wird, wenn sich die Steuereinheit (UC) in einem Modus mit reduziertem Verbrauch befindet,
- einen zweiten Versorgungsbereich (VIO), der so konfiguriert ist, dass er versorgt wird, wenn sich die Steuereinheit (UC) in dem Betriebsmodus und in dem Modus mit reduziertem Verbrauch befindet, wobei das Verfahren eine Konfiguration des Polarisationswerts des Eingangs (IN) des Speichers (MEM) über die Kommunikationsschnittstelle (COM) ausgehend von den ersten Konfigurationsmitteln (CONF1) der Steuereinheit (UC), die in dem ersten Versorgungsbereich (VCore) platziert sind, wenn sich die Steuereinheit (UC) in dem Betriebsmodus befindet, oder ausgehend von den zweiten Konfigurationsmitteln (CONF2) der Steuereinheit (UC), die in dem zweiten Versorgungsbereich (VIO) platziert sind, wenn sich die Steuereinheit (UC) in dem Modus mit reduziertem Verbrauch befindet, umfasst.

11. Verfahren nach Anspruch 10, ferner umfassend eine Auswahl durch Auswahlschaltungen (MS1, MS2) der ersten Konfigurationsmittel (CONF1) zum Konfigurieren des Polarisationswerts des Eingangs (IN) des Speichers (MEM), wenn sich die Steuereinheit (UC) in dem Betriebsmodus befindet, und der zweiten Konfigurationsmittel (CONF2) zum Konfigurieren des Polarisationswerts des Eingangs (IN) des Speichers (MEM), wenn sich die Steuereinheit (UC) in dem Modus mt reduziertem Verbrauch befindet.

12. Verfahren nach Anspruch 10 oder 11, umfassend das Anlegen eines logischen High-Zustands oder eines logischen Low-Zustands durch die ersten und zweiten Konfigurationsmittel (CONF1 und CONF2) an dem Eingang (IN) des Speichers (MEM).

13. Verfahren nach Anspruch 12, wobei:
- der logische High-Zustand von einem Pull-up-Widerstand (PU) angelegt wird, der so konfiguriert ist, dass er mit der Kommunikationsschnittstelle (COM) verbunden werden kann,
- der logische Low-Zustand von einem Rückstellwiderstand (PD) angelegt wird, der so konfiguriert ist, dass er mit der Kommunikationsschnittstelle (COM) verbunden werden kann, wobei das Verfahren ferner das Aktivieren oder Deaktivieren des Pull-up-Widerstands (PU) und des Rückstellwiderstands (PD) durch Schalter (MCPU, MCPD) je nach dem logischen Zustand, der an den Eingang (IN) des Speichers (MEM) angelegt werden soll, der durch die ersten und zweiten Konfigurationsmittel (CONF1 und CONF2) definiert ist, umfasst.

14. Verfahren nach Anspruch 13, wobei der Pull-up-Widerstand (PU) und der Rückstellwiderstand (PD) in einem Eingangs-/Ausgangsanschluss (IOP) der Steuereinheit (UC) vorgesehen sind, der so konfiguriert ist, dass er über die Kommunikationsschnittstelle (COM) mit dem Eingang (IN) des Speichers (MEM) verbunden ist.

15. Verfahren nach Anspruch 13, wobei der Pull-up-Widerstand (PU) und der Rückstellwiderstand (PD) mit der Kommunikationsschnittstelle (COM) zwischen der Steuereinheit (UC) und dem Speicher (MEM) verbunden sind.

16. Verfahren nach einem der Ansprüche 10 bis 15, wobei die Konfiguration des Polarisationswerts des Eingangs (IN) des Speichers (MEM) durch die ersten Konfigurationsmittel (CONF1) durch ein in den ersten Konfigurationsmitteln (CONF1) enthaltenes Konfigurationsregister (IPORT_PU, VCORE_CR_PD) definiert ist, wenn sich die Steuereinheit (UC) in dem Betriebsmodus befindet, wobei dieses Konfigurationsregister (IPORT_PU, VCORE_CR_PD) in einem Eingangs-/Ausgangsanschluss (IOP) der Steuereinheit (UC) vorgesehen ist, der so konfiguriert ist, dass er über die Kommunikationsschnittstelle (COM) mit dem Eingang (IN) des Speichers (MEM) verbunden werden kann.

17. Verfahren nach einem der Ansprüche 10 bis 16, wobei die Konfiguration des Polarisationswerts des Eingangs (IN) des Speichers (MEM) durch die zweiten Konfigurationsmittel (CONF2) durch ein in den zweiten Konfigurationsmitteln (CONF2) enthaltenes Konfigurationsregister (VIO_CR_PU, VIO_CR_PD) definiert ist, wenn sich die Steuereinheit (UC) in dem Modus mit reduziertem Verbrauch befindet, wobei dieses Konfigurationsregister (VIO_CR_PU, VIO_CR_PD) in einem Eingangs-/Ausgangsanschluss (IOP) der Steuereinheit (UC) vorgesehen ist, der so konfiguriert ist, dass er über die Kommunikationsschnittstelle (COM) mit dem Eingang (IN) des Speichers (MEM) verbunden werden kann.

18. Verfahren nach einem der Ansprüche 10 bis 17, wobei der Polarisationswert des zu konfigurierenden Eingangs (IN) des Speichers (MEM) geeignet ist, den Speicher (MEM) zu aktivieren oder deaktivieren, wobei das Verfahren ferner ein Deaktivieren des Speichers (MEM) bei dem Konfigurieren des Polarisationswerts des Eingangs (IN) des Speichers (MEM) durch die zweiten Konfigurationsmittel (CONF2) umfasst, wenn sich die Steuereinheit (UC) in dem Modus mit reduziertem Verbrauch befindet.

## Claims

1. System (SYS) comprising a control unit (UC) configured to be electrically connectable to an input (IN) of a memory (MEM) via a communication interface (COM), the control unit (UC) being adapted to have two power supply domains:
- a first power supply domain (VCore) configured to be powered when the control unit (UC) is in an operating mode and to be switched off when the control unit (UC) is in a low consumption mode,
- a second power supply domain (VIO) configured to be powered when the control unit (UC) is in the operating mode and in the low consumption mode,
wherein the control unit (UC) includes in the first power supply domain (VCore) first configuration means (CONF1) adapted to configure a polarization value of said input (IN) of the memory (MEM) via the communication interface (COM) when the control unit (UC) is in the operating mode, and **characterized in that** the control unit (UC) includes in the second power supply domain (VIO) second configuration means (CONF2) adapted to configure the polarization value of said input (IN) of the memory (MEM) via the communication interface (COM) when the control unit (UC) is in the low consumption mode.

2. System (SYS) according to claim 1, further comprising selection circuits (MS1 and MS2) configured to select said first configuration means (CONF1) to configure the polarization value of said input (IN) of the memory (MEM) when the control unit (UC) is in the operating mode or said second configuration means (CONF2) to configure the polarization value of said input (IN) of the memory (MEM) when the control unit (UC) is in low consumption mode.

3. System (SYS) according to any one of claims 1 or 2, wherein the first and second configuration means (CONF1 and CONF2) are adapted to apply a high logical state or a low logical state to the input (IN) of the memory (MEM).

4. System (SYS) according to claim 3, further comprising:
- a pull-up resistor (PU) configured to be connected to said communication interface (COM) for applying the high logical state to the input (IN) of the memory (MEM),
- a pull-down resistor (PD) configured to be connected to said communication interface (COM) for applying the low logical state to the input (IN) of the memory (MEM),
- switches (MCPU, MCPD) for activating or deactivating said pull-up resistor (PU) and said pull-down resistor (PD) according to the logical state to be applied to the input (IN) of the memory (MEM) defined by said first and second configuration means (CONF1 and CONF2).

5. System (SYS) according to claim 4, wherein said pull-up resistor (PU) and said pull-down resistor (PD) are provided in an input/output port (IOP) of the control unit (UC) configured to be connected to the input (IN) of the memory (MEM) via said communication interface (COM).

6. System (SYS) according to claim 4 comprising:
- the memory (MEM),
- said communication interface (COM) connecting the memory (MEM) to the control unit (UC), and wherein said pull-up resistor (PU) and said pull-down resistor (PD) are connected to the communication interface (COM) between the control unit (UC) and the memory (MEM).

7. System (SYS) according to one of claims 1 to 6, wherein the first configuration means (CONF1) comprise a configuration register (VCORE_CR_PU, VCORE_CR_PD) defining a configuration of the polarization value of the input (IN) of the memory (MEM) when the control unit (UC) is in the operating mode, this configuration register (VCORE_CR_PU, VCORE_CR_PD) being provided in an input/output port (IOP) of the control unit (UC) configured to be connected to the input (IN) of the memory (MEM) via said communication interface (COM).

8. System (SYS) according to one of claims 1 to 7, wherein the second configuration means (CONF2) comprise a configuration register (VIO_CR_PU, VIO_CR_PD) defining a configuration of the polarization value of the input (IN) of the memory (MEM) when the control unit (UC) is in the low consumption mode, this configuration register (VIO_CR_PU, VIO_CR_PD) being provided in an input/output port (IOP) of the control unit (UC) configured to be connected to the input (IN) of the memory (MEM) via said communication interface (COM).

9. System (SYS) according to one of claims 1 to 8, wherein the polarization value of the input (IN) of the memory (MEM) to be configured is adapted to activate or deactivate the memory (MEM), and wherein the second configuration means (CONF2) are adapted to configure this polarization value of the input (IN) of the memory (MEM) to deactivate the memory (MEM) when the control unit (UC) is in the low consumption mode.

10. Method for configuring a polarization value of an input (IN) of a memory (MEM) by a control unit (UC) electrically connected to the input (IN) of the memory (MEM) via a communication interface (COM), the control unit (UC) having two power supply domains:
- a first power supply domain (VCore) configured to be powered when the control unit (UC) is in an operating mode and to be switched off when the control unit (UC) is in a low consumption mode,
- a second power supply domain (VIO) configured to be powered when the control unit (UC) is in the operating mode and in the low consumption mode, the method comprising configuring the polarization value of the input (IN) of the memory (MEM) via the communication interface (COM) from first configuration means (CONF1) of the control unit (UC) placed in the first power supply domain (VCore) when the control unit (UC) is in the operating mode or from second configuration means (CONF2) of the control unit (UC) placed in the second power supply domain (VIO) when the control unit (UC) is in the low consumption mode.

11. Method according to claim 10, further comprising selecting by selection circuits (MS1, MS2) said first configuration means (CONF1) to configure the polarization value of the input (IN) of the memory (MEM) when the control unit (UC) is in operating mode and said second configuration means (CONF2) to configure the polarization value of the input (IN) of the memory (MEM) when the control unit (UC) is in low consumption mode.

12. Method according to claim 10 or 11, comprising applying by the first and second configuration means (CONF1 and CONF2) a high logical state or a low logical state to the input (IN) of the memory (MEM).

13. Method according to claim 12, wherein:
- the high logical state is applied by a pull-down resistor (PU) configured to be connected to said communication interface (COM),
- the low logical state is applied by a pull-down resistor (PD) configured to be connected to said communication interface (COM), the method further comprising activating or deactivating by switches (MCPU, MCPD) said pull-up resistor (PU) and said pull-down resistor (PD) according to the logical state to be applied to the input (IN) of the memory (MEM) defined by said first and second configuration means (CONF1 and CONF2).

14. Method according to claim 13, wherein said pull-up resistor (PU) and said pull-down resistor (PD) are provided in an input/output port (IOP) of the control unit (UC) configured to be connected to the input (IN) of the memory (MEM) via said communication interface (COM).

15. Method according to claim 13, wherein said pull-up resistor (PU) and said pull-down resistor (PD) are connected to the communication interface (COM) between the control unit (UC) and the memory (MEM).

16. Method according to one of claims 10 to 15, wherein the configuration of the polarization value of the input (IN) of the memory (MEM) by the first configuration means (CONF1) is defined by a configuration register (IPORT_PU, VCORE_CR_PD) included in the first configuration means (CONF1) when the control unit (UC) is in the operating mode, this configuration register (IPORT_PU, VCORE_CR_PD) being provided in an input/output port (IOP) of the control unit (UC) configured to be connected to the input (IN) of the memory (MEM) via said communication interface (COM).

17. Method according to one of claims 10 to 16, wherein the configuration of the polarization value of the input (IN) of the memory (MEM) by the second configuration means (CONF2) is defined by a configuration register (VIO_CR_PU, VIO_CR_PD) included in the second configuration means (CONF2) when the control unit (UC) is in the low consumption mode, this configuration register (VIO_CR_PU, VIO_CR_PD) being provided in an input/output port (IOP) of the control unit (UC) configured to be connected to the input (IN) of the memory (MEM) via said communication interface (COM).

18. Method according to one of claims 10 to 17, wherein the polarization value of the input (IN) of the memory (MEM) to be configured is adapted to activate or deactivate the memory (MEM), the method further comprising deactivating the memory (MEM) when configuring the polarization value of the input (IN) of the memory (MEM) by the second configuration means (CONF2) when the control unit (UC) is in the low consumption mode.
